# EUROPEAN PATENT SPECIFICATION

(11) **EP 3 696 863 B1**
(45) Date of publication and mention of the grant of the patent: **13.10.2021**
(21) Application number: 19157393.0
(22) Date of filing: 15.02.2019
(51) Int. Cl.: H01L 29/808, H01L 29/06, H01L 29/10, H01L 21/337, H01L 29/36, H01L 29/08, H01L 27/06, H01L 29/417

(54) **LATERAL TRANSISTOR DEVICE**
LATERALE TRANSISTORVORRICHTUNG
DISPOSITIF DE TRANSISTOR LATÉRAL

(43) Date of publication of application: 19.08.2020
(73) Proprietor: Infineon Technologies Austria AG, 9500 Villach (AT)
(72) Inventor: MAHMOUD, Ahmed, 81539 Muenchen (DE); WILLMEROTH, Armin, 86316 Friedberg (DE)
(74) Representative: Maikowski & Ninnemann Patentanwälte Partnerschaft mbB

(56) References cited:
- EP-A1- 1 487 024
- US-A1- 2003 057 479
- US-A1- 2005 269 660
- US-A1- 2011 127 606
- US-A1- 2012 199 848
- US-A1- 2017 092 716

## Description

### TECHNICAL FIELD

This specification is directed to embodiments of a power semiconductor die and to embodiments of a method of processing a power semiconductor die. In particular, this specification is directed to embodiments of a lateral transistor device and to corresponding embodiments of a manufacturing method.

### BACKGROUND

Many functions of modern devices in automotive, consumer and industrial applications, such as converting electrical energy and driving an electric motor or an electric machine, rely on power semiconductor devices.

For example, Insulated Gate Bipolar Transistors (IGBTs), Metal Oxide Semiconductor Field Effect Transistors (MOSFETs) and diodes, to name a few, have been used for various applications including, but not limited to switches in power supplies and power converters.

A power semiconductor device usually comprises a power semiconductor die configured to conduct a load current along a load current path between two load terminals of the device. A first load terminal, e.g., a source terminal, may be arranged at a front side of the die, and a second load terminal, e.g., a drain terminal, may be arranged at a back side of the die. The die may be included within a package of the power semiconductor device, wherein such package may provide for electrical connections to the load terminals.

Further, the load current path may be controlled by means of a control electrode, often referred to as gate electrode. For example, upon receiving a corresponding control signal from, e.g., a driver unit, the control electrode may set the power semiconductor die in one of a conducting state and a blocking state.

For a high blocking range, e.g., at 500V and above, superjunction MOSFETS are typically used, which provide for a low electrical resistivity in a conducting state. Moreover, due to the ongoing decrease in the size of semiconductor dies and a corresponding increase of an edge region in proportion to an active area of the die, lateral device structures have proved advantageous, as they have no inactive edge region.

A lateral superjunction device is described in the US 2011/127606 A1. A further lateral superjunction device is disclosed in EP 1 487 024 A1. That device comprises a substrate, a buffer layer of the first doping type, a plurality of alternately arranged layers of the first and second doping type forming the superjunction structure, a source and a drain region of the second doping type and a gate region.

The robustness of a lateral transistor device in blocking direction depends to a large extent on the snapback characteristic of the device. To ensure that snapback is avoided, e.g., when the device is switched from a conducting state into a blocking state, a current at which snapback occurs has to be significantly higher than the operating current of the device. Thus, as the snapback characteristic is device specific, it restricts an operating current suitable for the device.

A lateral transistor device which is robust to snapback is desirable.

### SUMMARY

According to a first aspect of the present invention, Z a lateral transistor device according to claim 1 is provided. The lateral transistor device comprises a layer stack with a plurality of first semiconductor layers of a first doping type and a plurality of second semiconductor layers of a second doping type complementary to the first doping type, a source region, a drain region spaced apart from the source region in a first lateral direction of the lateral transistor device, at least one gate region arranged between the source region and the drain region, a buffer layer arrangement, and a contact layer, wherein the buffer layer arrangement is arranged between the contact layer and at least parts of the layer stack, the source region and the drain region in a vertical direction of the lateral transistor device. The buffer layer arrangement comprises a first buffer layer and a second buffer layer, the second buffer layer being arranged between the first buffer layer and the contact layer, The first buffer layer, the second buffer layer and the contact layer have a same doping type, and a doping concentration of the second buffer layer is in a range between a doping concentration of the first buffer layer and a doping concentration of the contact layer. The source region and the drain region are of the second doping type. The doping concentration of the contact layer is higher than the doping concentration of the first buffer layer. The doping type of the first buffer layer, the second buffer layer and the contact layer is equal to the first doping type and the contact layer is coupled to a source potential of the lateral transistor device. Alternatively, the doping type of the first buffer layer, the second buffer layer and the contact layer is equal to the second doping type, the contact layer is coupled to a drain potential of the lateral transistor device, and the lateral transistor device further comprises an electrically isolating region of the first doping type connected to the source potential and isolating the source region from the contact layer.

According to a second aspect of the present invention, a method according to claim 14 for manufacturing a lateral transistor device is provided. The method comprises forming a contact layer configured to be in contact with a source potential or a drain potential of the lateral transistor device, forming a buffer layer arrangement on the contact layer in a vertical direction of the lateral transistor device, wherein the buffer layer arrangement comprises a first buffer layer and a second buffer layer, the second buffer layer being arranged between the first buffer layer and the contact layer, forming a layer stack with a plurality of first semiconductor layers of a first doping type and a plurality of second semiconductor layers of a second doping type complementary to the first doping type, a source region and a drain region spaced apart from the source region in a first lateral direction of the lateral transistor device, such that at least parts of the layer stack, the source region and the drain region are arranged on the buffer layer arrangement in the vertical direction of the lateral transistor device, and forming at least one gate region between the source region and the drain region. The first buffer layer, the second buffer layer and the contact layer have a same doping type, and a doping concentration of the second buffer layer is in a range between a doping concentration of the first buffer layer and a doping concentration of the contact layer. The source region and the drain region are of the second doping type. The doping concentration of the contact layer is higher than the doping concentration of the first buffer layer. The doping type of the first buffer layer, the second buffer layer and the contact layer is equal to the first doping type and the contact layer is coupled to a source potential of the lateral transistor device. Alternatively, the doping type of the first buffer layer, the second buffer layer and the contact layer is equal to the second doping type, the contact layer is coupled to a drain potential of the lateral transistor device, and the lateral transistor device further comprises an electrically isolating region of the first doping type connected to the source potential and isolating the source region from the contact layer.

Those skilled in the art will recognize additional features and advantages upon reading the following detailed description, and upon viewing the accompanying drawings.

### BRIEF DESCRIPTION OF THE DRAWINGS

The parts in the figures are not necessarily to scale, instead emphasis being placed upon illustrating principles of the invention. Moreover, in the figures, like reference numerals designate corresponding parts. In the drawings:
- Fig. 1: schematically and exemplarily illustrates a vertical cross-section of a lateral transistor device not forming part of the claimed invention;
- Fig. 2A: schematically and exemplarily illustrates a section of a vertical cross-section of the lateral transistor device of Fig. 1 and associated electrical field strengths;
- Fig. 2B: schematically and exemplarily illustrates an electric current associated with the electric field strengths of Fig. 2A;
- Fig. 3: schematically and exemplarily illustrates electrical field strength profiles for electrical currents around a snapback level of the lateral transistor device of Fig. 1;
- Figs. 4: schematically and exemplarily illustrates a vertical cross-section of a lateral transistor device according to an embodiment of the invention;
- Fig. 5A: schematically and exemplarily illustrates a section of a vertical cross-section of the lateral transistor device of Fig. 4 and an associated electrical field strength distribution;
- Fig. 5B: schematically and exemplarily illustrates electrical field strength profiles for electrical currents below a snapback level of the lateral transistor device of Fig. 4;
- Fig. 6: schematically and exemplarily illustrates electric current curves associated with the lateral transistor devices of Figs. 1 and 4;
- Fig. 7: schematically and exemplarily illustrates electric current curves associated with the lateral transistor device of Fig. 4 for different doping levels of the second buffer layer;
- Figs. 8 - 10: schematically and exemplarily illustrate vertical cross-sections of lateral transistor devices according to further inventive embodiments;
- Fig. 11: shows a flow diagram of a method for manufacturing a lateral transistor device according to an inventive embodiment.

### DETAILED DESCRIPTION

In the following detailed description, reference is made to the accompanying drawings which form a part hereof and in which are shown by way of illustration specific embodiments in which the invention may be practiced.

In this regard, directional terminology, such as "top", "bottom", "front", "behind", "back", "leading", "trailing", "below", "above" etc., may be used with reference to the 2018P51887EP orientation of the figures being described. Because parts of embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, therefore, is not to be taken in a limiting sense, and the scope of the present invention is defined by the appended claims.

Reference will now be made in detail to various embodiments, one or more examples of which are illustrated in the figures. Each example is provided by way of explanation, and is not meant as a limitation of the invention. For example, features illustrated or described as part of one embodiment can be used on or in conjunction with other embodiments to yield yet a further embodiment. It is intended that the present invention includes such modifications and variations. The examples are described using specific language which should not be construed as limiting the scope of the appended claims. The drawings are not scaled and are for illustrative purposes only. For clarity, the same elements or manufacturing steps have been designated by the same references in the different drawings if not stated otherwise.

The term "horizontal" as used in this specification intends to describe an orientation substantially parallel to a horizontal surface of a semiconductor substrate or of a semiconductor structure. This can be for instance the surface of a semiconductor wafer or a die or a chip. For example, both the (first) lateral direction X and the (second) lateral direction Y mentioned below can be horizontal directions, wherein the first lateral direction X and the second lateral direction Y may be perpendicular to each other.

The term "vertical" as used in this specification intends to describe an orientation which is substantially arranged perpendicular to the horizontal surface, i.e., parallel to the normal direction of the surface of the semiconductor wafer/chip/die. For example, the extension direction Z mentioned below may be an extension direction that is perpendicular to both the first lateral direction X and the second lateral direction Y.

In the context of the present specification, the terms "in ohmic contact", "in electric contact", "in ohmic connection", and "electrically connected" intend to describe that there is a low ohmic electric connection or low ohmic current path between two regions, sections, zones, portions or parts of the device described herein.

Further, in the context of the present specification, the term "in contact" intends to describe that there is a direct physical connection between two elements of the respective semiconductor device; e.g., a transition between two elements being in contact with each other may not include a further intermediate element or the like; i.e., said two elements may be in touch with each other.

In addition, in the context of the present specification, the term "electric insulation" is used, if not stated otherwise, in the context of its general valid understanding and thus intends to describe that two or more components are positioned separately from each other and that there is no ohmic connection connecting those components. However, components being electrically insulated from each other may nevertheless be coupled to each other, for example mechanically coupled and/or capacitively coupled and/or inductively coupled. To give an example, two electrodes of a capacitor may be electrically insulated from each other and, at the same time, mechanically and capacitively coupled to each other, e.g., by means of an insulation, e.g., a dielectric.

In this specification, p-doped is referred to as "first conductivity type", while n-doped is referred to as "second conductivity type". Alternatively, opposite doping relations can be employed so that the first conductivity type can be n-doped and the second conductivity type can be p-doped.

Specific embodiments described in this specification pertain to, without being limited thereto, a power semiconductor die, e.g., a power semiconductor die that may be used within a power converter or a power supply. For example, the power semiconductor die described herein is configured to be employed within power rectifier or within a power inverter, e.g., within a synchronous power rectifier or power inverter. For example, such rectifier/inverter is used as a part of a motor drive. Thus, in an embodiment, the power semiconductor die described herein can be configured to carry a part of a current that is to be fed to a load and/or, respectively, that is provided by a power source.

Accordingly, the term "power semiconductor die" as used in this specification intends to describe a single die with high voltage blocking and/or high current-carrying capabilities. In other words, such power semiconductor die is intended for high current, typically in the Ampere range, e.g., up to 5 or 300 Amperes, and/or voltages typically above 15 V, more typically up to 400 V, and above, e.g., up to at least 500 V or more than 500 V, e.g. at least 600 V. Further, the power semiconductor die described herein can be configured for high switching frequencies, e.g., for a switching frequency of at least 100 kHz and up to 2 MHz.

For example, the power semiconductor die described below may be a die that is configured to be employed as a power component in a low-, medium- and/or high voltage application.

Further, the term "power semiconductor die" as used in this specification is not directed to logic semiconductor devices that are used for, e.g., storing data, computing data and/or other types of semiconductor based data processing.

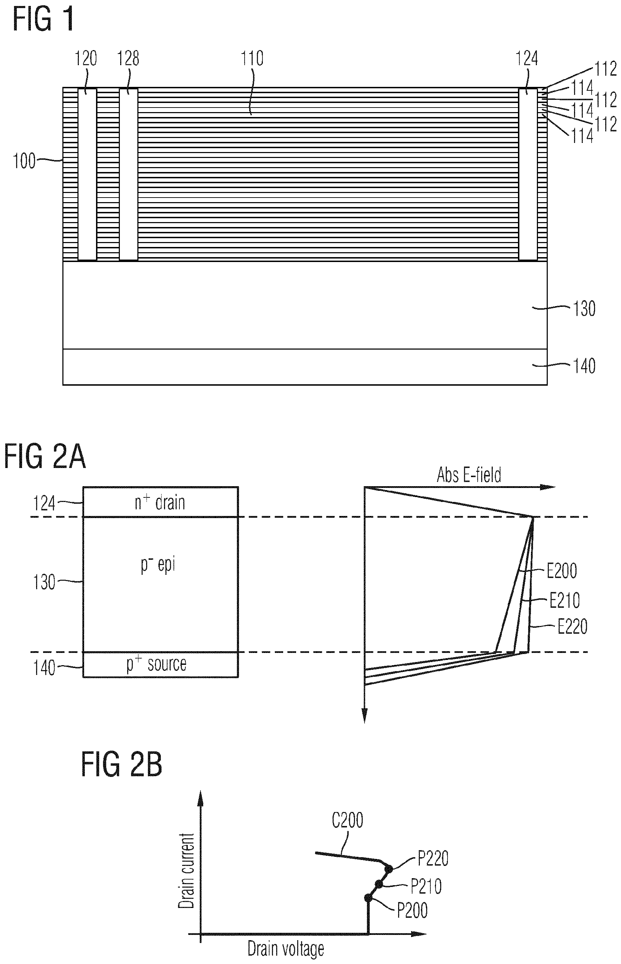

Fig. 1 shows schematically and exemplarily a vertical cross-section of a power semiconductor die 100, in the particular implementation as a lateral transistor device. The lateral transistor device 100 comprises on a buffer layer 130 a layer stack 110 of semiconductor layers. Further arranged on the buffer layer 130 are a source electrode 120, a drain electrode 124 and a gate electrode 128 of the lateral transistor device 100. The layer stack 110 comprises a plurality of first semiconductor layers 112 and a plurality of second semiconductor layers 114, which are arranged alternatingly in the layer stack 110. The first semiconductor layers 112 and the second semiconductor layers 114 constitute a superjunction region of the lateral transistor device 100. For that purpose, the first semiconductor layers are doped with a first doping type and the second semiconductor layers are doped with a second doping type complementary to the first doping type. In the shown example, the first semiconductor layers 112 and the second semiconductor layers 114 are stacked in a vertical direction of the lateral transistor device 100.

In the shown example, the buffer layer 130 has doping of the first doping type. Moreover, a region of the source electrode 120 as well as a region of the drain electrode 124 exhibit high doping of the second doping type.

The lateral transistor device 100 further comprises a contact layer 140 arranged under the buffer layer 130. In the shown example, the contact layer 140 has high doping of the first doping type. The contact layer 140 is electrically coupled to the source 120 and lies on the source potential. Electrically coupling the contact layer 140 to the source 120 is achieved, e.g., via a highly doped region of the first doping type extending from the contact layer 140 on the backside (not shown) of the lateral transistor device 100, wherein this backside contact is electrically connected to the source 120 via a metal connection, such as a metallized through silicon via, TSV, or external contacting, to account for the opposite doping of the backside contact and the source 120. However, in alternative implementations a doping of the buffer layer 130 is of the second doping type and the contact layer 140 is electrically coupled to, and lies on the potential of, the drain electrode 124. In this case, a backside contact extending from the contact layer 140 has, e.g., the same doping type as the source and the drain contact regions 120, 124. An electrical isolation between source 120 and backside contact is achieved, e.g., by a body region, such as a p-type region isolating the source 120 from the channel and being put on source potential, e.g., by ohmic coupling to a source metallization.

In the lateral transistor device 100, especially where the contact layer 140 and a backside contact are on the source potential, a snapback characteristic is influenced by the junction region in the laterally extending structure of the layer stack 110 as well as by the functionally vertical and quasi-one-dimensional structure from the highly doped drain region 124 via the buffer layer 130 to the contact layer 140. In particular, if the vertical structure between the drain region 124 and the contact layer 140 shows snapback at too low current densities, the entire lateral transistor device 100 will have an insufficient snapback robustness. Conversely, in examples of the lateral transistor device 100 having the backside contact on drain potential, the characteristics is influenced by the vertical structure between the above mentioned isolating p-region (e.g., as a body region) and the highly doped backside contact. The techniques described herein below relate to the snapback behavior of a lateral transistor device in connection with the vertical structure. The examples described herein below pertain to cases in which the contact layer 140 and a backside contact are on the source potential.

Fig. 2A shows on the left-hand side a section of the lateral transistor device 100 of Fig. 1 and, on the right-hand side, corresponding distributions of electrical field strength over the same section, dependent on a current through the drain region 124. The section shown on the left-hand side of Fig. 2A extends from a lower portion of the drain region 124, which in the shown example is a highly doped region of the second doping type. Beneath the drain region 124 there is shown a portion of the buffer layer 130 having a low doping concentration of the first doping type. Under the buffer layer 130 a portion of the contact layer 140 is shown, which has a high doping concentration of the first doping type, as described above.

The distribution E200 of the electrical field strength represents a distribution over the vertical structure in a static blocking state of the lateral transistor device 100. In this state, a peak of the electrical field is situated at the end of the highly doped drain region 124. As indicated by the other distributions E210, E220, with an increasing current density also the electrical field strength near the contact layer 140 at source potential increases. When the electrical field strength at the contact layer 140 reaches the level of the electrical field at the drain region 124, represented by the distribution E220, snapback occurs, i.e. a voltage between drain region 124 and the contact layer 140 starts to decrease with increasing current. If such current density is reached even destruction of the lateral transistor device 100 may occur in some cases.

Fig. 2B shows exemplarily the drain current C200 in relation to the drain voltage. On the curve C200 three points P200, P210, P220 are indicated. Each of the points P200, P210, P220 corresponds to one of the electrical field strength distributions E200, E210, E220, as shown in Fig. 2A, respectively. As shown in Fig. 2B, drain current and drain voltage are related positively between the points P200, P210, P220. However, at the critical point P220, the curve C200 starts to snap back, leading to a larger current at lower drain voltages.

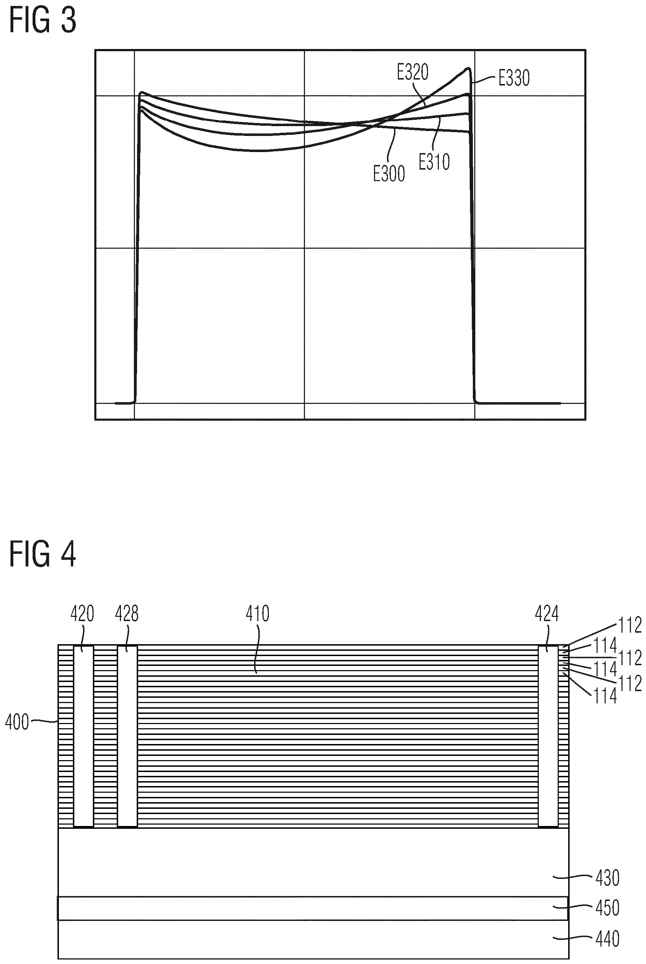

Fig. 3 shows simulation curves of the electrical field strength distribution over the thickness of the buffer layer 130 between drain region 124 and contact layer 144 for different current levels around the snapback level corresponding to point P220 of Fig. 2B. According to the simulation, the shown distributions E300, E310, E320 and E330 correspond to currents in the range between 15A and 50A, wherein the current increases from the distribution E300 towards the distribution E330.

As described in connection with Fig. 2A, the distribution E300 corresponds to a static blocking state, in which a peak of the electrical field strength distribution lies on the side of the drain region (left side of Fig. 3). With increasing current, a field strength on the source side (right hand side of Fig. 3) increases, until a peak of the electrical field strength moves towards the source side, as shown by the distributions E320 and E330. In these cases, snapback will occur.

Fig. 4 shows schematically and exemplarily a lateral transistor device 400. Unless otherwise clear from the following, the preceding discussion of the lateral transistor device 100 of Fig. 1 applies correspondingly to the lateral transistor device 400. In particular, similar to the lateral transistor device 100 the lateral transistor device 400 comprises a layer stack 410 with a plurality of first semiconductor layers 412 of a first doping type and a plurality of second semiconductor layers 414 of a second doping type complementary to the first doping type. Moreover, the lateral transistor device 400 comprises a source region 420, a drain region 424 spaced apart from the source region 420 in a lateral direction of the lateral transistor device 400, and a gate region 428 between the source region 420 and the drain region 424. In addition, the lateral transistor device 400 comprises a buffer layer arrangement 430, 450, on which the aforesaid features are arranged, and a contact layer 440 in contact with a source potential or a drain potential of the lateral transistor device 400. For the following description, it will again be assumed that the contact layer 440 is in contact with the source potential of the lateral transistor device 400.

Different from the example of Fig. 1, the lateral transistor device 400 comprises a buffer layer arrangement 430, 450 with a first buffer layer 430 and a second buffer layer 450, the second buffer layer 450 being arranged between the first buffer layer 430 and the contact layer 440. The first buffer layer 430, the second buffer layer 450 and the contact layer 440 have a same doping type. For the following example, it will be assumed that the first and second buffer layers 430, 450 and the contact layer 440 are of the first doping type. A doping concentration of the second buffer layer 450 is between the doping concentration of the first buffer layer 430 and the doping concentration of the contact layer 440.

In some examples, the doping concentration of the second buffer layer 450 is chosen to be within the range from 2 to 20 times the doping concentration of the first buffer layer 430. Moreover, in some examples the doping concentration of the first buffer layer 430 is chosen to be within a range from from 1*10^13/cm^3 to 1*10^15/cm^3 and the doping concentration of the second buffer layer is within a range from 0.6*10^14/cm^3 to 6*10^15/cm^3.

Furthermore, in some examples a doping concentration of the contact layer 440 is chosen to be within the range from 2 to 20 times the doping concentration of the second buffer layer 450. Moreover, in some examples the doping concentration of the second buffer layer 450 is chosen to be within range from 0.6^{*}10^14/cm^3 to 6^{*}10^15/cm^3 and the doping concentration of the contact layer is within a range from 1^{*}10^17/cm^3 to 1^{*}10^20/cm^3. In each of these examples, the doping concentration of the second buffer layer 450 is chosen to be within the range between the doping concentration of the first buffer layer 430 at the contact layer 450.

In some examples of thickness of the second buffer layer 450 is within the range from 5 µm to 20 µm, for example, in a range from 7 µm to 15 µm.

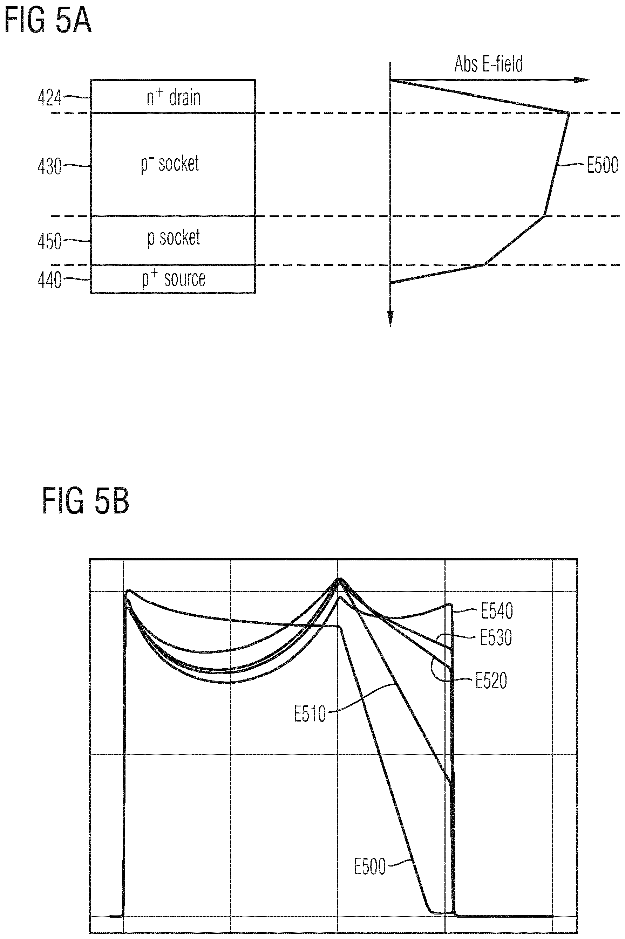

Fig. 5A shows schematically and exemplarily a section of the lateral transistor device 400 of Fig. 4 and a corresponding distribution of an electrical field strength over the section for a static blocking state. The left-hand side of Fig. 5A shows a section of the lateral transistor device 400 which includes the lower portion of the drain region 424, a portion of the first buffer layer 430 under the drain region 424, and a portion of the second buffer layer 450, which is arranged between the first buffer layer 430 and the contact layer 440. As in the example of Fig. 2A, it is assumed in the following that the contact layer 440 lies on the source potential and that the first and second buffer layers 430, 450 and the contact layer 440 are of the first doping type, wherein the doping concentration increases with each layer from the first buffer layer 430 towards the contact layer 440. However, in other examples, the contacted potential of the contact layer 440 and the doping type of the buffer layers 430, 450 and of the contact layer 440 may be inverse.

As shown on the right-hand side of Fig. 5A, a peak of the electrical field strength distribution is again located at the end of the drain region 424. However, as an effect of the second buffer layer 450 being arranged between the first buffer layer 430 and the contact layer 440, a stronger reduction of the electrical field strength towards the contact layer 440 is achieved.

Fig. 5B shows electrical field strength profiles over the vertical structure shown in Fig. 5A for different current levels, as simulation results similar to Fig. 3. The electrical field strength distributions E500, E510, E520, E530 and E540 correspond to a gradually increasing drain current. Discontinuities in the slope and/or curvature of the distributions around the middle of the diagram correspond to an electrical field strength around the interface between the first buffer layer 430 and the second buffer layer 450.

As is apparent from Fig. 5B, with an increasing drain current a peak of the electrical field strength distribution shifts from the drain region 424 (left-hand side of Fig. 5B) towards the interfacing region of the first and second buffer layers 430, 450. Furthermore, the peak of the electrical field strength distribution tends to remain at that interfacing region even for relatively high drain currents, before shifting further towards contact layer 440 (right-hand side of Fig. 5B). A shift of the peak to the source potential is about to occur for drain currents slightly larger than the current corresponding to the distribution 540. Accordingly, for none of the shown distributions in Fig. 5B a snapback condition occurs.

Thus, the provision of the second buffer layer 450 as described above provides for a higher snapback robustness of the lateral transistor device 400 in comparison to the lateral transistor device 100 of Fig. 1. In particular, a snapback characteristic of the vertical structure between drain or source region and the contact layer is improved by the provision of a second buffer layer as described.

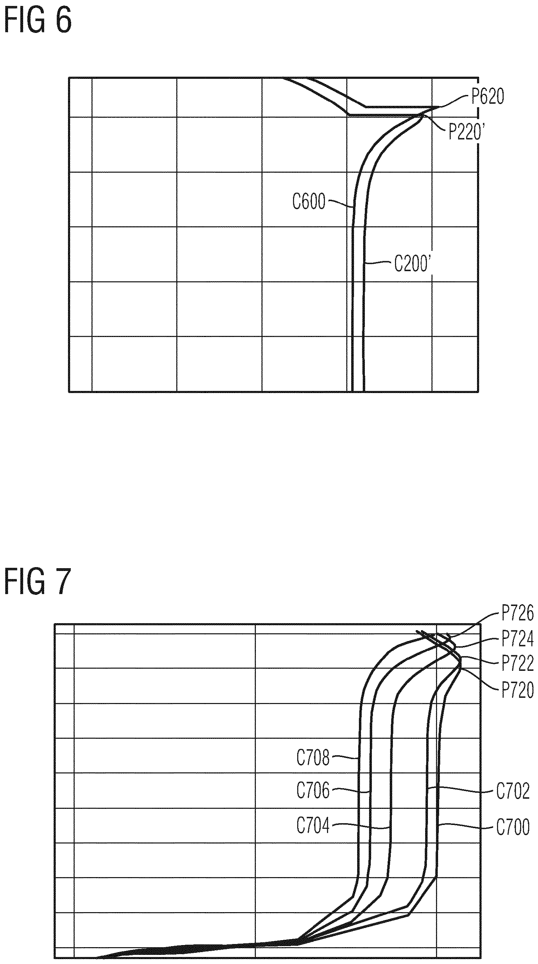

Fig. 6 shows schematically and exemplarily drain currents C200', C600 in relation to a drain voltage for the lateral transistor device 100 of Fig. 1 and the lateral transistor device 400 of Fig. 4, respectively. In this case, the simulation further takes into account a snapback influence of the lateral junction structure. The drain current of the transistor device 100 is represented by the curve C200' and the drain current of the lateral transistor device 400 is represented by the curve C600. As can be seen, a critical point P220', at which snapback occurs with the lateral transistor device 100, corresponds to a lower drain current than the critical point P620, at which snapback would occur with the lateral transistor device 400 comprising the second buffer layer 450. The difference between the drain currents at the critical points P220' and P620 corresponds to an increased snapback robustness achieved by means of the second buffer layer.

Fig. 7 shows drain currents dependent on voltage for each of different doping concentrations of the second buffer layer 450. The curves C700, C702, C704, C706, C708 correspond in this order to an increasing doping concentration of the second buffer layer. For the simulation, concentrations in the range from 10^14/cm^3 to 12^14/cm^3 were chosen. As can be seen, over the chosen range an increased doping concentration in the second buffer layer leads to an increased critical current represented by the critical points P720, P722, P724 and P726 corresponding to an increased snapback robustness.

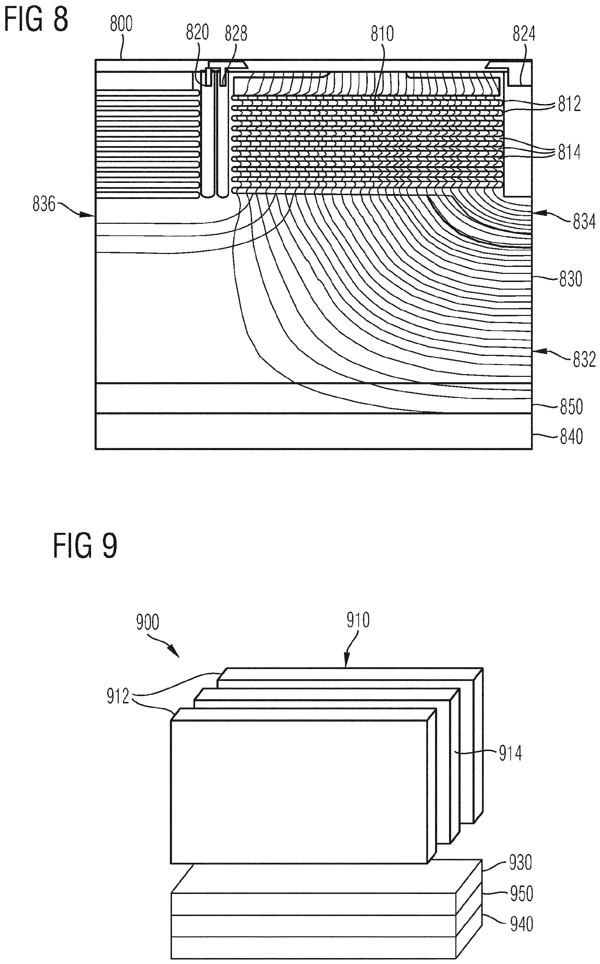

Fig. 8 shows schematically and exemplarily another example of a lateral transistor device 800. Unless otherwise clear from the following, the above discussion of the lateral transistor device 400 of Fig. 4 applies correspondingly. In particular, the lateral transistor device 800 also comprises a layer stack 810 comprising first semiconductor layers 812 and second semiconductor layers 814, a source region 820, a drain region 824, and a gate region 828 arranged on the first buffer layer 830, as well as a second buffer layer 850 arranged between the first buffer layer 830 and a contact layer 840.

The lateral transistor device 800 of the shown example is a junction gate field effect transistor, in which the layer stack 810 constitutes a superjunction region. In the shown example, the source region 820 and the drain region 824 are arranged to adjoin the second semiconductor layers 814, which function as drift regions, whereas the first semiconductor layers 812 function as compensation regions, of the superjunction transistor. Furthermore, the first buffer layer comprises regions 834, 836 having a locally different doping than the doping of the first buffer layer 830 in another region 832 adjacent to the second buffer layer 850. The preceding discussion regarding a doping concentration of the first buffer layer 830 in relation to the second buffer 850 apply in particular to the doping in the region 832 adjacent to the second buffer layer 850.

Fig. 9 shows schematically and exemplarily another example of a lateral transistor device 900. Unless otherwise clear from the following, the preceding discussion of the lateral transistor devices 400, 800 applies correspondingly. In particular, the lateral transistor device 900 also comprises a layer stack 910 with first and second semiconductor layers 912, 914 arranged on a first buffer layer 930, as well as a second buffer layer 950 arranged between the first buffer layer 930 and a contact layer 940. Different from the previous examples, the first semiconductor layers 912 and the second semiconductor layers 914 of the lateral transistor device 900 are stacked in a lateral direction of the lateral transistor device 900. The lateral direction in which the first and second semiconductor layers 912, 914 are stacked is different from the first lateral direction in which a source region (not shown) and a drain region (not shown) of the lateral transistor device 900 are spaced.

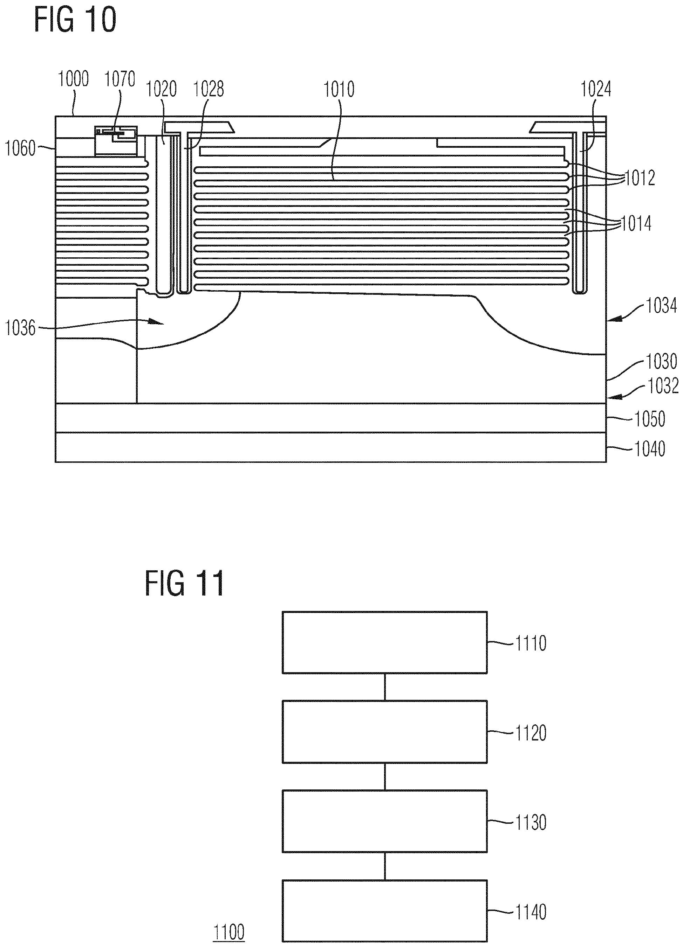

Fig. 10 shows schematically and exemplarily another example of a lateral transistor device 1000. Unless otherwise clear from the following, the preceding discussion of the lateral transistor device 800 of Fig. 8 applies correspondingly. In particular, the lateral transistor device 1000 also comprises a layer stack 1010 with first semiconductor layers and second semiconductor layers 1014, a source region 1020, a drain region 1024 and a gate region 1028 which are arranged on the first buffer layer 1030, as well as a second buffer layer 1050 arranged between the first buffer layer 1030 and contact layer 1040. Moreover, within the first buffer layer 1030 regions 1034, 1036 with a locally different doping than another region 1032 of the first buffer layer 1030 adjacent to the second buffer layer 1050 are provided.

Different from the lateral transistor device of Fig. 8, the lateral transistor device 1000 further comprises a control transistor device 1070 with active regions being integrated within a semiconductor layer 1060 of the lateral transistor device 1000. The control transistor device 1070 may be arranged in cascode with the junction gate field effect transistor constituted by the aforesaid features of the lateral transistor device 1000.

Fig. 11 shows a flow chart of a method 1100 for manufacturing a lateral transistor device, in particular a lateral transistor device as described above. The method 1100 comprises forming a contact layer which is configured to be in contact with a source potential or a drain potential of the lateral transistor device, block 1110. The method 1100 further comprises forming a buffer layer arrangement on the contact layer in a vertical direction of the lateral transistor device, wherein the buffer layer arrangement comprises a first buffer layer and a second buffer layer, the second buffer layer being arranged between the first buffer layer and the contact layer, block 1120. The method 1100 further comprises forming a layer stack with a plurality of first semiconductor layers of a first doping type and plurality of second semiconductor layers of a second doping type complimentary to the first doping time, as well as a source region and a drain region spaced apart from the source region in a first lateral direction of the lateral transistor device, such that at least parts of the layer stack, the source region and the drain region are arranged on the buffer layer arrangement in the vertical direction of the lateral transistor device, 1130. The method 1100 further comprises forming at least one gate region between the source region and the drain region, block 1140. The first buffer layer, the second buffer layer and the contact layer have a same doping type, and a doping concentration of the second buffer layer is in a range between the doping concentration of the first buffer layer and a doping concentration of the contact layer.

In the above, embodiments pertaining to power semiconductor dies and corresponding processing methods were explained. For example, these semiconductor dies are based on silicon (Si). Accordingly, a monocrystalline semiconductor region or layer or section can be a monocrystalline Si-region or Si-layer. In other embodiments, polycrystalline or amorphous silicon may be employed.

It should, however, be understood that the semiconductor die can be made of any semiconductor material suitable for manufacturing a semiconductor die. Examples of such materials include, without being limited thereto, elementary semiconductor materials such as silicon (Si) or germanium (Ge), group IV compound semiconductor materials such as silicon carbide (SiC) or silicon germanium (SiGe), binary, ternary or quaternary III-V semiconductor materials such as gallium nitride (GaN), gallium arsenide (GaAs), gallium phosphide (GaP), indium phosphide (InP), indium gallium phosphide (InGaPa), aluminum gallium nitride (AIGaN), aluminum indium nitride (AllnN), indium gallium nitride (InGaN), aluminum gallium indium nitride (AIGalnN) or indium gallium arsenide phosphide (InGaAsP), and binary or ternary II-VI semiconductor materials such as cadmium telluride (CdTe) and mercury cadmium telluride (HgCdTe) to name few. The aforementioned semiconductor materials are also referred to as "homojunction semiconductor materials". When combining two different semiconductor materials a heterojunction semiconductor material is formed. Examples of heterojunction semiconductor materials include, without being limited thereto, aluminum gallium nitride (AIGaN)-aluminum gallium indium nitride (AIGalnN), indium gallium nitride (InGaN)-aluminum gallium indium nitride (AIGalnN), indium gallium nitride (InGaN)-gallium nitride (GaN), aluminum gallium nitride (AIGaN)-gallium nitride (GaN), indium gallium nitride (InGaN)-aluminum gallium nitride (AIGaN), silicon-silicon carbide (SixC1-x) and silicon-SiGe heterojunction semiconductor materials. For power semiconductor devices applications currently mainly Si, SiC, GaAs and GaN materials are used.

Spatially relative terms such as "under", "below", "lower", "over", "upper" and the like, are used for ease of description to explain the positioning of one element relative to a second element. These terms are intended to encompass different orientations of the respective device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising", "exhibiting" and the like are open ended terms that indicate the presence of stated elements or features, but do not preclude additional elements or features.

With the above range of variations and applications in mind, it should be understood that the present invention is not limited by the foregoing description, nor is it limited by the accompanying drawings. Instead, the present invention is limited only by the following claims.

## Claims

1. A lateral transistor device (400; 800; 900; 1000) comprising:
a layer stack (410; 810; 910; 1010) with a plurality of first semiconductor layers (412; 812; 912; 1012) of a first doping type and a plurality of second semiconductor layers (414; 814; 914; 1014) of a second doping type complementary to the first doping type,
a source region (420; 820; 1020), the source region being of the second doping type;
a drain region (424; 824; 1024) spaced apart from the source region (420; 820; 1020) in a first lateral direction of the lateral transistor device, the drain region being of the second doping type;
at least one gate region (428; 828; 1028) arranged between the source region (420; 820; 1020) and the drain region (424; 824; 1024);
a buffer layer arrangement (430, 450; 830, 850; 930, 950; 1030, 1050), and
a contact layer (440; 840; 940; 1040), wherein the buffer layer arrangement (430, 450; 830, 850; 930, 950; 1030, 1050) is arranged between the contact layer (440; 840; 940; 1040) and at least parts of the layer stack (410; 810; 910; 1010), the source region (420; 820; 1020) and the drain region (424; 824; 1024) in a vertical direction of the lateral transistor device,
wherein:
the buffer layer arrangement (430, 450; 830, 850; 930, 950; 1030, 1050) comprises a first buffer layer (430; 830; 930; 1030) and a second buffer layer (450; 850; 950; 1050), the second buffer layer (450; 850; 950; 1050) being arranged between the first buffer layer (430; 830; 930; 1050) and the contact layer (440; 840; 940; 1040), and
the first buffer layer (430; 830; 930; 1030), the second buffer layer (450; 850; 950; 1050) and the contact layer (440; 840; 940; 1040) have a same doping type, and a doping concentration of the second buffer layer (450; 850; 950; 1050) is in a range between a doping concentration of the first buffer layer (430; 830; 930; 1030) and a doping concentration of the contact layer (440; 840; 940; 1040), the doping concentration of the contact layer (440; 840; 940; 1040) being higher than the doping concentration of the first buffer layer (430; 830; 930; 1030);
wherein the doping type of the first buffer layer (430; 830; 930; 1030), the second buffer layer (450; 850; 950; 1050) and the contact layer (440; 840; 940; 1040) is equal to the first doping type and the contact layer (440; 840; 940; 1040) is coupled to a source potential of the lateral transistor device, or
wherein the doping type of the first buffer layer (430; 830; 930; 1030), the second buffer layer (450; 850; 950; 1050) and the contact layer (440; 840; 940; 1040) is equal to the second doping type, the contact layer (440; 840; 940; 1040) is coupled to a drain potential of the lateral transistor device, and the lateral transistor device further comprises an electrically isolating region of the first doping type connected to the source potential and isolating the source region (420; 820; 1020) from the contact layer (440; 840; 940; 1040).

2. The lateral transistor device of claim 1, wherein a doping concentration of the second buffer layer (450; 850; 950; 1050) is within a range from 2 to 20 times a doping concentration of the first buffer layer (430; 830; 930; 1030).

3. The lateral transistor device of claim 1 or 2, wherein the doping concentration of the first buffer layer (430; 830; 930; 1030) is within a range from 1^{*}10^13/cm^3 to 1^{*}10^15/cm^3 and the doping concentration of the second buffer layer (450; 850; 950; 1050) is within a range from 0.6^{*}10^14/cm^3 to 6^{*}10^15/cm^3.

4. The lateral transistor device of any of the preceding claims, wherein a doping concentration of the contact layer (440; 840; 940; 1040) is within a range from 2 to 20 times a doping concentration of the second buffer layer (450; 850; 950; 1050).

5. The lateral transistor device of any of the preceding claims, wherein the doping concentration of the second buffer layer (450; 850; 950; 1050) is within a range from 0.6^{*}10^14/cm^3 to 6^{*}10^15/cm^3 and the doping concentration of the contact layer (440; 840; 940; 1040) is within a range from 1^{*}10^17/cm^3 to 1^{*}10^20/cm^3.

6. The lateral transistor device of any of the preceding claims, wherein a thickness of the second buffer layer (450; 850; 950; 1050) is within a range from 5µm to 20µm.

7. The lateral transistor device of any of the preceding claims, wherein the plurality of first semiconductor layers (412; 812; 1012) and the plurality of second semiconductor layers (414; 814; 1014) are stacked in the vertical direction of the lateral transistor device.

8. The lateral transistor device of any one of claims 1 to 6, wherein the plurality of first semiconductor layers (912) and the plurality of second semiconductor layers (914) are stacked in a second lateral direction of the lateral transistor device.

9. The lateral transistor device of claim 8, wherein the second lateral direction is perpendicular to the first lateral direction.

10. The lateral transistor device of any of the preceding claims, wherein the first doping type includes a p-dopant and the second doping type includes an n-dopant.

11. The lateral transistor device of any of the preceding claims, wherein the doping concentration of the first buffer layer (830; 1030) is a first doping concentration of the first buffer layer in a first region (832; 1032) of the first buffer layer, the first region (832; 1032) adjoining the second buffer layer (850; 1050), and wherein the first buffer layer (830; 1030) has at least one second region (834, 836; 1034, 1036) having at least one of a doping type and a doping concentration different from the doping type and the doping concentration of the first region (832; 1032).

12. The lateral transistor device of any of the preceding claims, wherein the lateral transistor device comprises a junction gate field-effect transistor, and the layer stack (410; 810; 910; 1010) is configured to constitute a superjunction region of the junction gate field-effect transistor.

13. The lateral transistor device of claim 12, further comprising a control transistor device (1070), wherein active regions of the control transistor device (1070) are integrated in a semiconductor layer (1060) of the junction gate field-effect transistor and wherein the control transistor device (1070) is configured for controlling an operation state of the junction gate field-effect transistor.

14. A method (1100) for manufacturing a lateral transistor device, the method comprising:
forming (1110) a contact layer configured to be in contact with a source potential or a drain potential of the lateral transistor device;
forming (1120) a buffer layer arrangement on the contact layer in a vertical direction of the lateral transistor device, wherein the buffer layer arrangement comprises a first buffer layer and a second buffer layer, the second buffer layer being arranged between the first buffer layer and the contact layer;
forming (1130) a layer stack with a plurality of first semiconductor layers of a first doping type and a plurality of second semiconductor layers of a second doping type complementary to the first doping type, a source region and a drain region spaced apart from the source region in a first lateral direction of the lateral transistor device, such that at least parts of the layer stack, the source region and the drain region are arranged on the buffer layer arrangement in the vertical direction of the lateral transistor device, the source region and the drain region being of the second doping type, and
forming (1140) at least one gate region between the source region and the drain region;
wherein:
the first buffer layer, the second buffer layer and the contact layer have a same doping type, and a doping concentration of the second buffer layer is in a range between a doping concentration of the first buffer layer and a doping concentration of the contact layer, the doping concentration of the contact layer being higher than the doping concentration of the first buffer layer;
the doping type of the first buffer layer (430; 830; 930; 1030), the second buffer layer (450; 850; 950; 1050) and the contact layer (440; 840; 940; 1040) is equal to the first doping type and the contact layer (440; 840; 940; 1040) is coupled to a source potential of the lateral transistor device, or the doping type of the first buffer layer (430; 830; 930; 1030), the second buffer layer (450; 850; 950; 1050) and the contact layer (440; 840; 940; 1040) is equal to the second doping type, the contact layer (440; 840; 940; 1040) is coupled to a drain potential of the lateral transistor device, and the lateral transistor device further comprises an electrically isolating region of the first doping type connected to the source potential and isolating the source region (420; 820; 1020) from the contact layer (440; 840; 940; 1040) .

## Patentansprüche

1. Lateraltransistorbauelement (400; 800; 900; 1000), umfassend:
einen Schichtstapel (410; 810; 910; 1010) mit mehreren ersten Halbleiterschichten (412; 812; 912; 1012) von einem ersten Dotiertyp und mehreren zweiten Halbleiterschichten (414; 814; 914; 1014) von einem zu dem ersten Dotiertyp komplementären zweiten Dotiertyp,
ein Sourcegebiet (420; 820; 1020), wobei das Sourcegebiet von dem zweiten Dotiertyp ist;
ein von dem Sourcegebiet (420; 820; 1020) in einer ersten Lateralrichtung des Lateraltransistorbauelements beabstandetes Draingebiet (424; 824; 1024), wobei das Draingebiet von dem zweiten Dotiertyp ist;
mindestens ein zwischen dem Sourcegebiet (420; 820; 1020) und dem Draingebiet (424; 824; 1024) angeordnetes Gategebiet (428; 828; 1028);
eine Pufferschichtanordnung (430, 450; 830, 850; 930, 950; 1030, 1050), und
eine Kontaktschicht (440; 840; 940; 1040), wobei die Pufferschichtanordnung (430, 450; 830, 850; 930, 950; 1030, 1050) zwischen der Kontaktschicht (440; 840; 940; 1040) und mindestens Teilen des Schichtstapels (410; 810; 910; 1010), dem Sourcegebiet (420; 820; 1020) und dem Draingebiet (424; 824; 1024) in einer vertikalen Richtung des Lateraltransistorbauelements angeordnet ist,
wobei die Pufferschichtanordnung (430, 450; 830, 850; 930, 950; 1030, 1050) eine erste Pufferschicht (430; 830; 930; 1030) und eine zweite Pufferschicht (450; 850; 950; 1050) umfasst, wobei die zweite Pufferschicht (450; 850; 950; 1050) zwischen der ersten Pufferschicht (430; 830; 930; 1050) und der Kontaktschicht (440; 840; 940; 1040) angeordnet ist, und
die erste Pufferschicht (430; 830; 930; 1030), die zweite Pufferschicht (450; 850; 950; 1050) und die Kontaktschicht (440; 840; 940; 1040) einen gleichen Dotiertyp aufweisen und eine Dotierkonzentration der zweiten Pufferschicht (450; 850; 950; 1050) zwischen einer Dotierkonzentration der ersten Pufferschicht (430; 830; 930; 1030) und einer Dotierkonzentration der Kontaktschicht (440; 840; 940; 1040) liegt, wobei die Dotierkonzentration der Kontaktschicht (440; 840; 940; 1040) höher ist als die Dotierkonzentration der ersten Pufferschicht (430; 830; 930; 1030);
wobei der Dotiertyp der ersten Pufferschicht (430; 830; 930; 1030), der zweiten Pufferschicht (450; 850; 950; 1050) und der Kontaktschicht (440; 840; 940; 1040) gleich dem ersten Dotiertyp ist und die Kontaktschicht (440; 840; 940; 1040) an ein Sourcepotential des Lateraltransistorbauelements gekoppelt ist, oder
wobei der Dotiertyp der ersten Pufferschicht (430; 830; 930; 1030), der zweiten Pufferschicht (450; 850; 950; 1050) und der Kontaktschicht (440; 840; 940; 1040) gleich dem zweiten Dotiertyp ist, die Kontaktschicht (440; 840; 940; 1040) an ein Drainpotential des Lateraltransistorbauelements gekoppelt ist und das Lateraltransistorbauelement weiter ein elektrisch isolierendes Gebiet vom ersten Dotiertyp, mit dem Sourcepotential verbunden und das Sourcegebiet (420; 820; 1020) von der Kontaktschicht (440; 840; 940; 1040) isolierend, umfasst.

2. Lateraltransistorbauelement nach Anspruch 1, wobei eine Dotierkonzentration der zweiten Pufferschicht (450; 850; 950; 1050) innerhalb eines Bereichs vom Zweifachen bis Zwanzigfachen einer Dotierkonzentration der ersten Pufferschicht (430; 830; 930; 1030) liegt.

3. Lateraltransistorbauelement nach Anspruch 1 oder 2, wobei die Dotierkonzentration der ersten Pufferschicht (430; 830; 930; 1030) innerhalb eines Bereichs von 1^{*}10^13/cm^3 bis 1^{*}10^15/cm^3 liegt und die Dotierkonzentration der zweiten Pufferschicht (450; 850; 950; 1050) innerhalb eines Bereichs von 0,6^{*}10^14/cm^3 bis 6^{*}10^15/cm^3 liegt.

4. Lateraltransistorbauelement nach einem der vorhergehenden Ansprüche, wobei eine Dotierkonzentration der Kontaktschicht (440; 840; 940; 1040) innerhalb eines Bereichs vom Zweifachen bis Zwanzigfachen einer Dotierkonzentration der zweiten Pufferschicht (450; 850; 950; 1050) liegt.

5. Lateraltransistorbauelement nach einem der vorhergehenden Ansprüche, wobei die Dotierkonzentration der zweiten Pufferschicht (450; 850; 950; 1050) innerhalb eines Bereichs von 0,6^{*}10^14/cm^3 bis 6^{*}10^15/cm^3 liegt und die Dotierkonzentration der Kontaktschicht (440; 840; 940; 1040) innerhalb eines Bereichs von 1^{*}10^17/cm^3 bis 1^{*}10^20/cm^3 liegt.

6. Lateraltransistorbauelement nach einem der vorhergehenden Ansprüche, wobei eine Dicke der zweiten Pufferschicht (450; 850; 950; 1050) innerhalb eines Bereichs von 5 µm bis 20pm liegt.

7. Lateraltransistorbauelement nach einem der vorhergehenden Ansprüche, wobei die mehreren ersten Halbleiterschichten (412; 812; 1012) und die mehreren zweiten Halbleiterschichten (414; 814; 1014) in der vertikalen Richtung des Lateraltransistorbauelements gestapelt sind.

8. Lateraltransistorbauelement nach einem der Ansprüche 1 bis 6, wobei die mehreren ersten Halbleiterschichten (912) und die mehreren zweiten Halbleiterschichten (914) in einer zweiten lateralen Richtung des Lateraltransistorbauelements gestapelt sind.

9. Lateraltransistorbauelement nach Anspruch 8, wobei die zweite laterale Richtung senkrecht zu der ersten lateralen Richtung verläuft.

10. Lateraltransistorbauelement nach einem der vorhergehenden Ansprüche, wobei der erste Dotiertyp einen p-Dotierstoff enthält und der zweite Dotiertyp einen n-Dotierstoff enthält.

11. Lateraltransistorbauelement nach einem der vorhergehenden Ansprüche, wobei die Dotierkonzentration der ersten Pufferschicht (830; 1030) eine erste Dotierkonzentration der ersten Pufferschicht in einem ersten Gebiet (832; 1032) der ersten Pufferschicht ist, wobei das erste Gebiet (832; 1032) an die zweite Pufferschicht (850; 1050) angrenzt, und wobei die erste Pufferschicht (830; 1030) mindestens ein zweites Gebiet (834, 836; 1034, 1036) mit mindestens einem eines Dotiertyps und einer Dotierkonzentration aufweist, die von dem Dotiertyp und der Dotierkonzentration des ersten Gebiets (832; 1032) verschieden sind.

12. Lateraltransistorbauelement nach einem der vorhergehenden Ansprüche, wobei das Lateraltransistorbauelement einen Sperrschichtfeldeffekttransistor umfasst und der Schichtstapel (410; 810; 910; 1010) ausgelegt ist zum Bilden eines Supersperrschichtgebiets des Sperrschichtfeldeffekttransistors.

13. Lateraltransistorbauelement nach Anspruch 12, weiter umfassend ein Steuertransistorbauelement (1070), wobei aktive Gebiete des Steuertransistorbauelements (1070) in einer Halbleiterschicht (1060) des Sperrschichtfeldeffekttransistors integriert sind und wobei das Steuertransistorbauelement (1070) ausgelegt ist zum Steuern eines Arbeitszustands des Sperrschichtfeldeffekttransistors.

14. Verfahren (1100) zum Herstellen eines Lateraltransistorbauelements, wobei das Verfahren umfasst:
Bilden (1110) einer Kontaktschicht, die ausgelegt ist, um mit einem Sourcepotential oder einem Drainpotential des Lateraltransistorbauelements in Kontakt zu sein;
Bilden (1120) einer Pufferschichtanordnung auf der Kontaktschicht in einer vertikalen Richtung des Lateraltransistorbauelements, wobei die Pufferschichtanordnung eine erste Pufferschicht und eine zweite Pufferschicht umfasst, wobei die zweite Pufferschicht zwischen der ersten Pufferschicht und der Kontaktschicht angeordnet ist;
Bilden (1030) eines Schichtstapels mit mehreren ersten Halbleiterschichten von einem ersten Dotiertyp und mehreren zweiten Halbleiterschichten von einem zu dem ersten Dotiertyp komplementären zweiten Dotiertyp, einem Sourcegebiet und einem Draingebiet, beabstandet von dem Sourcegebiet in einer ersten lateralen Richtung des Lateraltransistorbauelements, so dass mindestens Teile des Schichtstapels, des Sourcegebiets und des Draingebiets auf der Pufferschichtanordnung in der vertikalen Richtung des Lateraltransistorbauelements angeordnet sind, das Sourcegebiet und das Draingebiet vom zweiten Dotiertyp sind, und
Bilden (1140) mindestens eines Gategebiets zwischen dem Sourcegebiet und dem Draingebiet;
wobei:
die erste Pufferschicht, die zweite Pufferschicht und die Kontaktschicht einen gleichen Dotiertyp aufweisen und eine Dotierkonzentration der zweiten Pufferschicht in einem Bereich zwischen einer Dotierkonzentration der ersten Pufferschicht und einer Dotierkonzentration der Kontaktschicht liegt, wobei die Dotierkonzentration der Kontaktschicht über der Dotierkonzentration der ersten Pufferschicht liegt;
der Dotiertyp der ersten Pufferschicht (430; 830; 930; 1030), der zweiten Pufferschicht (450; 850; 950; 1050) und der Kontaktschicht (440; 840; 940; 1040) gleich dem ersten Dotiertyp ist und die Kontaktschicht (440; 840; 940; 1040) an ein Sourcepotential des Lateraltransistorbauelements gekoppelt ist, oder der Dotiertyp der ersten Pufferschicht (430; 830; 930; 1030), der zweiten Pufferschicht (450; 850; 950; 1050) und der Kontaktschicht (440; 840; 940; 1040) gleich dem zweiten Dotiertyp ist, die Kontaktschicht (440; 840; 940; 1040) an ein Drainpotential des Lateraltransistorbauelements gekoppelt ist, und das Lateraltransistorbauelement weiter ein elektrisch isolierendes Gebiet vom ersten Dotiertyp, mit dem Sourcepotential verbunden und das Sourcegebiet (420; 820; 1020) von der Kontaktschicht (440; 840; 940; 1040) isolierend, umfasst.

## Revendications

1. Dispositif transistor latéral (400 ; 800 ; 900 ; 1000) comprenant :
un empilement de couches (410 ; 810 ; 910 ; 1010) avec une pluralité de premières couches semi-conductrices (412 ; 812 ; 912 ; 1012) d'un premier type de dopage et une pluralité de deuxièmes couches semi-conductrices (414 ; 814 ; 914 ; 1014) d'un deuxième type de dopage complémentaire du premier type de dopage ;
une région de source (420 ; 820 ; 1020), la région de source étant du deuxième type de dopage ;
une région de drain (424 ; 824 ; 1024) espacée de la région de source (420 ; 820 ; 1020) dans une première direction latérale du dispositif transistor latéral, la région de drain étant du deuxième type de dopage ;
au moins une région de grille (428 ; 828 ; 1028) disposée entre la région de source (420 ; 820 ; 1020) et la région de drain (424 ; 824 ; 1024) ;
un agencement de couches tampons (430, 450 ; 830, 850 ; 930, 950 ; 1030, 1050) ; et
une couche de contact (440 ; 840 ; 940 ; 1040), l'agencement de couches tampons (430, 450 ; 830, 850 ; 930, 950 ; 1030, 1050) étant disposé entre la couche de contact (440 ; 840 ; 940 ; 1040) et au moins des parties de l'empilement de couches (410 ; 810 ; 910 ; 1010), de la région de source (420 ; 820 ; 1020) et de la région de drain (424 ; 824 ; 1024) dans une direction verticale du dispositif transistor latéral,
dans lequel :
l'agencement de couches tampons (430, 450 ; 830, 850 ; 930, 950 ; 1030, 1050) comprend une première couche tampon (430 ; 830 ; 930 ; 1030) et une deuxième couche tampon (450 ; 850 ; 950 ; 1050), la deuxième couche tampon (450 ; 850 ; 950 ; 1050) étant disposée entre la première couche tampon (430 ; 830 ; 930 ; 1050) et la couche de contact (440 ; 840 ; 940 ; 1040), et
la première couche tampon (430 ; 830 ; 930 ; 1030), la deuxième couche tampon (450 ; 850 ; 950 ; 1050) et la couche de contact (440 ; 840 ; 940 ; 1040) ont un même type de dopage, et une concentration de dopage de la deuxième couche tampon (450 ; 850 ; 950 ; 1050) se situe dans une gamme entre une concentration de dopage de la première couche tampon (430 ; 830 ; 930 ; 1030) et une concentration de dopage de la couche de contact (440 ; 840 ; 940 ; 1040), la concentration de dopage de la couche de contact (440 ; 840 ; 940 ; 1040) étant supérieure à la concentration de dopage de la première couche tampon (430 ; 830 ; 930 ; 1030) ;
dans lequel le type de dopage de la première couche tampon (430 ; 830 ; 930 ; 1030), de la deuxième couche tampon (450 ; 850 ; 950 ; 1050) et de la couche de contact (440 ; 840 ; 940 ; 1040) est identique au premier type de dopage et la couche de contact (440 ; 840 ; 940 ; 1040) est couplée à un potentiel de source du dispositif transistor latéral, ou
dans lequel le type de dopage de la première couche tampon (430 ; 830 ; 930 ; 1030), de la deuxième couche tampon (450 ; 850 ; 950 ; 1050) et de la couche de contact (440 ; 840 ; 940 ; 1040) est identique au deuxième type de dopage, la couche de contact (440 ; 840 ; 940 ; 1040) est couplée à un potentiel de drain du dispositif transistor latéral, et le dispositif transistor latéral comprend en outre une région électriquement isolante du premier type de dopage reliée au potentiel de source et isolant la région de source (420 ; 820 ; 1020) de la couche de contact (440 ; 840 ; 940 ; 1040).

2. Dispositif transistor latéral de la revendication 1, dans lequel une concentration de dopage de la deuxième couche tampon (450 ; 850 ; 950 ; 1050) se situe dans une gamme de 2 à 20 fois une concentration de dopage de la première couche tampon (430 ; 830 ; 930 ; 1030).

3. Dispositif transistor latéral de la revendication 1 ou 2, dans lequel la concentration de dopage de la première couche tampon (430 ; 830 ; 930 ; 1030) se situe dans une gamme de 1*10¹³/cm3 à 1*10¹⁵/cm3 et la concentration de dopage de la deuxième couche tampon (450 ; 850 ; 950 ; 1050) se situe dans une gamme de 0,6*10¹⁴/cm3 à 6*10¹⁵/cm3.

4. Dispositif transistor latéral de l'une quelconque des revendications précédentes, dans lequel une concentration de dopage de la couche de contact (440 ; 840 ; 940 ; 1040) se situe dans une gamme de 2 à 20 fois une concentration de dopage de la deuxième couche tampon (450 ; 850 ; 950 ; 1050).

5. Dispositif transistor latéral de l'une quelconque des revendications précédentes, dans lequel la concentration de dopage de la deuxième couche tampon (450 ; 850 ; 950 ; 1050) se situe dans une gamme de 0,6*10¹⁴/cm3 à 6*10¹⁵/cm3 et la concentration de dopage de la couche de contact (440 ; 840 ; 940 ; 1040) se situe dans une gamme de 1^{*}10¹⁷/CM³ à 1^{*}10²¹/CM³.

6. Dispositif transistor latéral de l'une quelconque des revendications précédentes, dans lequel une épaisseur de la deuxième couche tampon (450 ; 850 ; 950 ; 1050) se situe dans une gamme de 5 µm à 20 pm.

7. Dispositif transistor latéral de l'une quelconque des revendications précédentes, dans lequel la pluralité de premières couches semi-conductrices (412 ; 812 ; 1012) et la pluralité de deuxièmes couches semi-conductrices (414 ; 814 ; 1014) sont empilées dans la direction verticale du dispositif transistor latéral.

8. Dispositif transistor latéral de l'une quelconque des revendications 1 à 6, dans lequel la pluralité de premières couches semi-conductrices (912) et la pluralité de deuxièmes couches semi-conductrices (914) sont empilées dans une deuxième direction latérale du dispositif transistor latéral.

9. Dispositif transistor latéral de la revendication 8, dans lequel la deuxième direction latérale est perpendiculaire à la première direction latérale.

10. Dispositif transistor latéral de l'une quelconque des revendications précédentes, dans lequel le premier type de dopage comporte un dopant p et le deuxième type de dopage comporte un dopant n.

11. Dispositif transistor latéral de l'une quelconque des revendications précédentes, dans lequel la concentration de dopage de la première couche tampon (830 ; 1030) est une première concentration de dopage de la première couche tampon dans une première région (832 ; 1032) de la première couche tampon, la première région (832 ; 1032) jouxtant la deuxième couche tampon (850 ; 1050), et dans lequel la première couche tampon (830 ; 1030) a au moins une deuxième région (834, 836 ; 1034, 1036) ayant un type de dopage et/ou une concentration de dopage différents du type de dopage et de la concentration de dopage de la première région (832 ; 1032).

12. Dispositif transistor latéral de l'une quelconque des revendications précédentes, le dispositif transistor latéral comprenant un transistor à effet de champ à grille de jonction, et l'empilement de couches (410 ; 810 ; 910 ; 1010) étant configuré pour constituer une région de superjonction du transistor à effet de champ à grille de jonction.

13. Dispositif transistor latéral de la revendication 12, comprenant en outre un dispositif transistor de contrôle (1070), des régions actives du dispositif transistor de contrôle (1070) étant intégrées dans une couche semi-conductrice (1060) du transistor à effet de champ à grille de jonction et le dispositif transistor de contrôle (1070) étant configuré pour contrôler un état de fonctionnement du transistor à effet de champ à grille de jonction.

14. Procédé (1100) de fabrication d'un dispositif transistor latéral, le procédé comprenant :
la formation (1110) d'une couche de contact configurée pour être en contact avec un potentiel de source ou un potentiel de drain du dispositif transistor latéral ;
la formation (1120) d'un agencement de couches tampons sur la couche de contact dans une direction verticale du dispositif transistor latéral, l'agencement de couches tampons comprenant une première couche tampon et une deuxième couche tampon, la deuxième couche tampon étant disposée entre la première couche tampon et la couche de contact ;
la formation (1130) d'un empilement de couches avec une pluralité de premières couches semi-conductrices d'un premier type de dopage et une pluralité de deuxièmes couches semi-conductrices d'un deuxième type de dopage complémentaire du premier type de dopage, d'une région de source et d'une région de drain espacée de la région de source dans une première direction latérale du dispositif transistor latéral, de telle sorte qu'au moins des parties de l'empilement de couches, de la région de source et de la région de drain sont disposées sur l'agencement de couches tampons dans la direction verticale du dispositif transistor de latérale, la région de source et la région de drain étant du deuxième type de dopage ; et
la formation (1140) d'au moins une région de grille entre la région de source et la région de drain ;
dans lequel :
la première couche tampon, la deuxième couche tampon et la couche de contact ont un même type de dopage, et une concentration de dopage de la deuxième couche tampon se situe dans une gamme entre une concentration de dopage de la première couche tampon et une concentration de dopage de la couche de contact, la concentration de dopage de la couche de contact étant supérieure à la concentration de dopage de la première couche tampon ;
le type de dopage de la première couche tampon (430 ; 830 ; 930 ; 1030), de la deuxième couche tampon (450 ; 850 ; 950 ; 1050) et de la couche de contact (440 ; 840 ; 940 ; 1040) est identique au premier type de dopage et la couche de contact (440 ; 840 ; 940 ; 1040) est couplée à un potentiel de source du dispositif transistor latéral, ou le type de dopage de la première couche tampon (430 ; 830 ; 930 ; 1030), de la deuxième couche tampon (450 ; 850 ; 950 ; 1050) et de la couche de contact (440 ; 840 ; 940 ; 1040) est identique au deuxième type de dopage, la couche de contact (440 ; 840 ; 940 ; 1040) est couplée à un potentiel de drain du dispositif transistor latéral, et le dispositif transistor latéral comprend en outre une région électriquement isolante du premier type de dopage reliée au potentiel de source et isolant la région de source (420 ; 820 ; 1020) de la couche de contact (440 ; 840 ; 940 ; 1040).
